# EUROPEAN PATENT APPLICATION

(11) **EP 4 618 082 A1**
(43) Date of publication of application: **17.09.2025**
(21) Application number: 25154787.3
(22) Date of filing: 29.01.2025
(51) Int. Cl.: G11C 7/06, G11C 11/22

(54) **NEGATIVE FEEDBACK THRESHOLD COMPENSATION FOR SENSE AMPLIFIERS**

(30) Priority: 29.02.2024 US 202463559626 P; 25.07.2024 US 202418783764
(71) Applicant: Micron Technology, Inc, Boise ID 83707 (US)
(72) Inventor: LIU, Tong, BOISE (US); VIMERCATI, Daniele, BOISE (US)
(74) Representative: Grassi, Stefano

(57) **Abstract**

Systems and methods are related to a memory device including a plate line. The memory device also includes a pair of ferroelectric layers implementing a pair of memory cells and coupled to opposite sides of the plate line. The memory device further includes a pair of digit lines each coupled to a respective ferroelectric layer of the pair of ferroelectric layers. The memory device also includes a sense amplifier coupled to the pair of digit lines and configured to sense and amplify voltages received at the pair of digit lines from the respective memory cells. The sense amplifier includes a pair of inverters configured to selectively couple to the pair of digit lines and a pair of switches each configured to cause a respective inverter of the pair of inverters to function as a unity gain amplifier during a compensation phase of the memory device.

## Description

### BACKGROUND

### Field of the Present Disclosure

Embodiments of the present disclosure relate generally to memory devices. More specifically, embodiments of the present disclosure relate to compensating for different characteristics of negative feedback amplifiers of sense amplifiers of a memory device.

### Description of Related Art

Generally, a computing system may include electronic devices that, in operation, communicate information via electrical signals. For example, a computing system may include a processor communicatively coupled to a memory device, such as a dynamic random-access memory (DRAM) device, a ferroelectric random-access memory (FeRAM) device, another random-access memory (RAM) device, and/or a hybrid device that incorporates more than one type of RAM. In this manner, the processor may communicate with the memory device, for example, to retrieve executable instructions, retrieve data to be processed, by the processor, and/or store data output from the processor.

The memory devices utilize sense amplifiers during read operations. Specifically, the read circuitry of the memory device utilizes the sense amplifiers to receive low voltage (e.g., low differential) signals and amplify the small voltage (e.g., voltage differences) to enable the memory device to interpret the data properly. Some embodiments of the memory device may use multiple negative feedback/inverting amplifiers for a single cell. However, these different negative feedback/inverting amplifiers may have different characteristics, such as different thicknesses, aging, other general process variations, and/or any differences in the transistors used to form the negative feedback/inverting amplifiers even if the transistors are intended to be the same between the negative feedback/inverting amplifiers. These differences, even if relatively small, will be amplified during signal development and amplification. These amplified differences may negatively impact the operation of the sense amplifier potentially causing misinterpretation of data stored in the cells.

Embodiments of the present disclosure may be directed to one or more of the problems set forth above.

### BRIEF DESCRIPTION OF THE DRAWINGS

FIG. 1 is a simplified block diagram illustrating certain features of a memory device having sense amplifiers and memory cells, according to an embodiment of the present disclosure;
FIG. 2 is a top view of lines of ferroelectric memory cells of FIG. 1 and a side view of the lines in the memory cells of FIG. 1, according to an embodiment of the present disclosure;
FIG. 3 is a circuit diagram of a connection of the lines of FIG. 2 to a sense amplifier of FIG. 3, according to an embodiment of the present disclosure;
FIG. 4 is a circuit diagram of the embodiment of the sense amplifier of FIG. 3 using a negative voltage and negative feedback amplifiers, according to an embodiment of the present disclosure;
FIG. 5 is a graph and timing diagram of operation of the sense amplifier of FIG. 4, according to an embodiment of the present disclosure;
FIG. 6 is a diagram showing a representation of a negative feedback amplifier of FIG. 4 with a corresponding gain function, according to an embodiment of the present disclosure;
FIG. 7 is a circuit diagram of the embodiment of the sense amplifier of FIG. 3 using a ground voltage and negative feedback amplifiers, according to an embodiment of the present disclosure; and
FIG. 8 is a graph and timing diagram of operation of the sense amplifier of FIG. 7, according to an embodiment of the present disclosure.

### DETAILED DESCRIPTION

One or more specific embodiments will be described below. To provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Generally, a computing system may include electronic devices that, in operation, communicate information via electrical signals. For example, electronic devices in a computing system may include a processor communicatively coupled to memory. In this manner, the processor may communicate with memory to retrieve executable instructions, retrieve data to be processed by the processor, and/or store data output from the processor.

FeRAM memory technology utilization is increasing due to various possible market directions. As discussed below, FeRAM may be implemented with one-transistor, one-capacitor (1T1C) per cell or two-transistor, two-capacitor (2T2C) per cell arrangements. In the 2T2C arrangement, two cells are used for a single bit of data. One cell stores the data while another cell stores the complement of the data. The first cell is coupled to a digit line (DL) while the second is coupled to a digit line bar/false (DLB). A sense amplifier receives both signals from the DL and the DLB as a differential signal.

As discussed below, the 1T1C arrangement understandably uses less space than the 2T2C arrangement. However, the 2T2C accommodates faster speeds that may be used to obtain performances close or the same as DRAM specification requirements to enable the FeRAM to be compliant with DRAM specifications in dedicated FeRAM devices or hybrid DRAM/FeRAM devices. Thus, timing of various FeRAM operations may be important to comply with DRAM specified timings.

Furthermore, like DRAM, FeRAM utilizes a memory restore to restore memory values from latches back to the memory cells after a read. Specifically, each cell is programmed "0" and then cells that previously stored a "1" are programmed as such from the latches. Such programming of 1s may be conducted after writes are completed and may consume important time that is to be streamlined to comply with DRAM requirements.

Additionally, the differential signals from the DL and DLB to the sense amplifier may be relatively small (e.g., 50 mV - 150 mV). Furthermore, due to the transistors used in the 2T2C or 1T1C arrangements, the operating voltage of the sense amplifier may be capped at a low level (e.g., 1.2 V). At such relatively small differences in voltages for the 2T2C arrangement, differences in the transistors (or the inverters they implement) may potentially cause issues in interpreting data from the memory cells. As discussed below, by enhancing and/or optimizing the response of the different inverters based on specific characteristics of different inverters differently may cause the fidelity of the sense amplifiers to be improved.

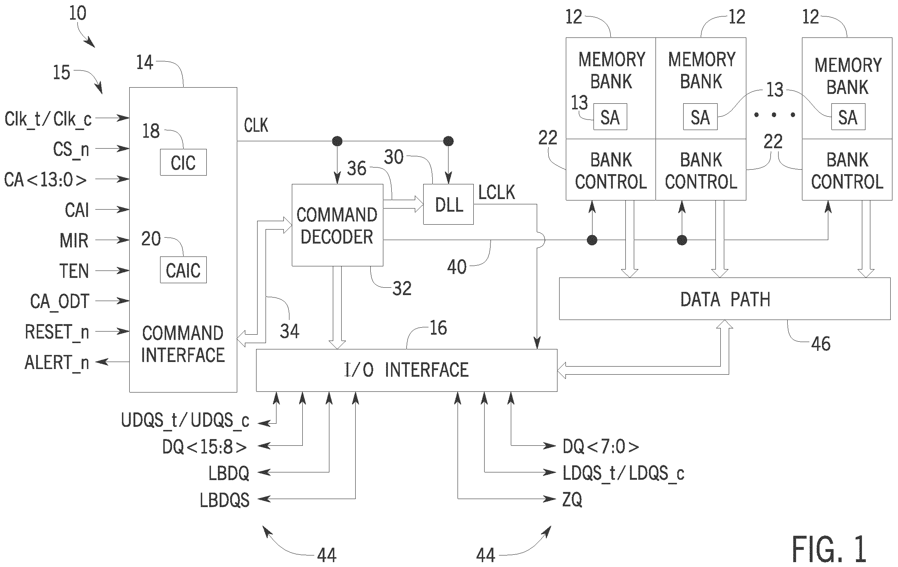

Turning now to the figures, FIG. 1 is a simplified block diagram illustrating certain features of a memory device 10. Specifically, the block diagram of FIG. 1 is a functional block diagram illustrating certain functionality of the memory device 10. In accordance with one embodiment, the memory device 10 may be a double data rate type five synchronous dynamic random-access memory (DDR5 SDRAM) device, a ferroelectric memory (FeRAM) device, or a hybrid combination thereof. Various features of memory device 10 allow for reduced power consumption, more bandwidth and more storage capacity compared to prior generations of DDR SDRAM.

The memory device 10 may include a number of memory banks 12. The memory banks 12 may be DDR5 SDRAM memory banks, FeRAM memory banks, or both, for instance. The memory banks 12 may be provided on one or more chips (e.g., SDRAM and FeRAM chips) that are arranged on dual inline memory modules (DIMMS). Each DIMM may include a number of memory chips (e.g., x8 or x16 memory chips), as will be appreciated. Each memory chip may include one or more memory banks 12. The memory device 10 represents a portion of a single memory chip having a number of memory banks 12. The memory banks 12 may be further arranged to form bank groups. For instance, for an 8 gigabyte (Gb) DDR5 SDRAM, the memory chip may include 16 memory banks 12, arranged into 8 bank groups, each bank group including 2 memory banks. For a 16 Gb DDR5 SDRAM, the memory chip may include 32 memory banks 12, arranged into 8 bank groups, each bank group including 4 memory banks, for instance. Various other configurations, organization, and sizes of the memory banks 12 on the memory device 10 may be utilized depending on the application and design of the overall system.

The memory banks 12 and/or bank control blocks 22 include sense amplifiers 13. As previously noted, sense amplifiers 13 are used by the memory device 10 during read operations. Specifically, read circuitry of the memory device 10 utilizes the sense amplifiers 13 to receive low voltage (e.g., low differential) signals from the memory cells of the memory banks 12 and amplifies the small voltage differences to enable the memory device 10 to interpret the data properly.

The memory device 10 may include a command interface 14 and an input/output (I/O) interface 16. The command interface 14 is configured to provide a number of signals (e.g., signals 15) from an external (e.g., host) device (not shown), such as a processor or controller. The processor or controller may provide various signals 15 to the memory device 10 to facilitate the transmission and receipt of data to be written to or read from the memory device 10.

As will be appreciated, the command interface 14 may include a number of circuits, such as a clock input circuit 18 and a command address input circuit 20, for instance, to ensure proper handling of the signals 15. The command interface 14 may receive one or more clock signals from an external device. Generally, double data rate (DDR) memory utilizes a differential pair of system clock signals, the true clock signal Clk_t and the bar clock signal Clk_c. The positive clock edge for DDR refers to the point where the rising true clock signal Clk_t crosses the falling bar clock signal Clk_c, while the negative clock edge indicates that transition of the falling true clock signal Clk_t and the rising of the bar clock signal Clk_c. Commands (e.g., read command, write command, etc.) are typically entered on the positive edges of the clock signal and data is transmitted or received on both the positive and negative clock edges.

The clock input circuit 18 receives the true clock signal Clk_t and the bar clock signal Clk_c and generates an internal clock signal CLK. The internal clock signal CLK is supplied to an internal clock generator, such as a delay locked loop (DLL) circuit 30. The DLL circuit 30 generates a phase controlled internal clock signal LCLK based on the received internal clock signal CLK. The phase controlled internal clock signal LCLK is supplied to the I/O interface 16, for instance and is used as a timing signal for determining an output timing of read data. In some embodiments, the clock input circuit 18 may include circuitry that splits the clock signal into multiple (e.g., 4) phases. The clock input circuit 18 may also include phase detection circuitry to detect which phase receives a first pulse when sets of pulses occur too frequently to enable the clock input circuit 18 to reset between sets of pulses.

The internal clock signal(s)/phases CLK may also be provided to various other components within the memory device 10 and may be used to generate various additional internal clock signals. For instance, the internal clock signal CLK may be provided to a command decoder 32. The command decoder 32 may receive command signals from the command bus 34 and may decode the command signals to provide various internal commands. For instance, the command decoder 32 may provide command signals to the DLL circuit 30 over the bus 36 to coordinate generation of the phase controlled internal clock signal LCLK. The phase controlled internal clock signal LCLK may be used to clock data through the IO interface 16, for instance.

Further, the command decoder 32 may decode commands, such as read commands, write commands, mode-register set commands, activate commands, etc., and provide access to a particular memory bank 12 corresponding to the command, via the bus path 40. As will be appreciated, the memory device 10 may include various other decoders, such as row decoders and column decoders, to facilitate access to the memory banks 12. In one embodiment, each memory bank 12 includes the bank control block 22 which provides the necessary decoding (e.g., row decoder and column decoder), as well as other features, such as timing control and data control, to facilitate the execution of commands to and from the memory banks 12.

The memory device 10 executes operations, such as read commands and write commands, based on the command/address signals received from an external device, such as a processor. In one embodiment, the command/address bus may be a 14-bit bus to accommodate the command/address signals (CA<13:0>). The command/address signals are clocked to the command interface 14 using the clock signals (Clk_t and Clk_c). The command interface may include a command address input circuit 20, which is configured to receive and transmit the commands to provide access to the memory banks 12, through the command decoder 32, for instance. In addition, the command interface 14 may receive a chip select signal (CS_n). The CS_n signal enables the memory device 10 to process commands on the incoming CA<13:0> bus. Access to specific banks 12 within the memory device 10 is encoded on the CA<13:0> bus with the commands.

In addition, the command interface 14 may be configured to receive a number of other command signals. For instance, a command/address on die termination (CA_ODT) signal may be provided to facilitate proper impedance matching within the memory device 10. A reset command (RESET_n) may be used to reset the command interface 14, status registers, state machines and the like, during power-up for instance. The command interface 14 may also receive a command/address invert (CAI) signal which may be provided to invert the state of command/address signals CA<13:0> on the command/address bus, for instance, depending on the command/address routing for the particular memory device 10. A mirror (MIR) signal may also be provided to facilitate a mirror function. The MIR signal may be used to multiplex signals so that they can be swapped for enabling certain routing of signals to the memory device 10, based on the configuration of multiple memory devices in a particular application. Various signals to facilitate testing of the memory device 10, such as the test enable (TEN) signal, may be provided, as well. For instance, the TEN signal may be used to place the memory device 10 into a test mode for connectivity testing.

The command interface 14 may also be used to provide an alert signal (ALERT_n) to the system processor or controller for certain errors that may be detected. For instance, an alert signal (ALERT_n) may be transmitted from the memory device 10 if a cyclic redundancy check (CRC) error is detected. Other alert signals may also be generated. Further, the bus and pin for transmitting the alert signal (ALERT_n) from the memory device 10 may be used as an input pin during certain operations, such as the connectivity test mode executed using the TEN signal, as described above.

Data may be sent to and from the memory device 10, utilizing the command and clocking signals discussed above, by transmitting and receiving data signals 44 through the IO interface 16. More specifically, the data may be sent to or retrieved from the memory banks 12 over the datapath 46, which includes a plurality of bi-directional data buses. Data IO signals, generally referred to as DQ signals, are generally transmitted and received in one or more bi-directional data busses. For certain memory devices, such as a DDRS SDRAM memory device, the IO signals may be divided into upper and lower bytes. For instance, for a x16 memory device, the IO signals may be divided into upper and lower IO signals (e.g., DQ<15:8> and DQ<7:0>) corresponding to upper and lower bytes of the data signals, for instance.

To allow for higher data rates within the memory device 10, certain memory devices, such as DDR memory devices may utilize data strobe signals, generally referred to as DQS signals. The DQS signals are driven by the external processor or controller sending the data (e.g., for a write command) or by the memory device 10 (e.g., for a read command). For read commands, the DQS signals are effectively additional data output (DQ) signals with a predetermined pattern. For write commands, the DQS signals are used as clock signals to capture the corresponding input data. As with the clock signals (Clk_t and Clk_c), the DQS signals may be provided as a differential pair of data strobe signals (DQS_t and DQS_c) to provide differential pair signaling during reads and writes. For certain memory devices, such as a DDRS SDRAM memory device, the differential pairs of DQS signals may be divided into upper and lower data strobe signals (e.g., UDQS_t and UDQS_c; LDQS_t and LDQS_c) corresponding to upper and lower bytes of data sent to and from the memory device 10, for instance.

An impedance (ZQ) calibration signal may also be provided to the memory device 10 through the IO interface 16. The ZQ calibration signal may be provided to a reference pin and used to tune output drivers and ODT values by adjusting pull-up and pull-down resistors of the memory device 10 across changes in process, voltage, and temperature (PVT) values. Because PVT characteristics may impact the ZQ resistor values, the ZQ calibration signal may be provided to the ZQ reference pin to be used to adjust the resistance to calibrate the input impedance to known values. As will be appreciated, a precision resistor is generally coupled between the ZQ pin on the memory device 10 and GND/VSS external to the memory device 10. This resistor acts as a reference for adjusting internal ODT and drive strength of the IO pins.

In addition, a loopback data signal (LBDQ) and loopback strobe signal (LBDQS) may be provided to the memory device 10 through the IO interface 16. The loopback data signal and the loopback strobe signal may be used during a test or debugging phase to set the memory device 10 into a mode wherein signals are looped back through the memory device 10 through the same pin. For instance, the loopback signal may be used to set the memory device 10 to test the data output (DQ) of the memory device 10. Loopback may include both LBDQ and LBDQS or possibly just a loopback data pin. This is generally intended to be used to monitor the data captured by the memory device 10 at the IO interface 16. LBDQ may be indicative of a target memory device, such as memory device 10, data operation and, thus, may be analyzed to monitor (e.g., debug and/or perform diagnostics on) data operation of the target memory device. Additionally, LBDQS may be indicative of a target memory device, such as memory device 10, strobe operation (e.g., clocking of data operation) and, thus, may be analyzed to monitor (e.g., debug and/or perform diagnostics on) strobe operation of the target memory device.

As will be appreciated, various other components such as power supply circuits (for receiving external VDD and VSS signals), mode registers (to define various modes of programmable operations and configurations), read/write amplifiers (to amplify signals during read/write operations), temperature sensors (for sensing temperatures of the memory device 10), etc., may also be incorporated into the memory device 10. Accordingly, it should be understood that the block diagram of FIG. 1 is only provided to highlight certain functional features of the memory device 10 to aid in the subsequent detailed description.

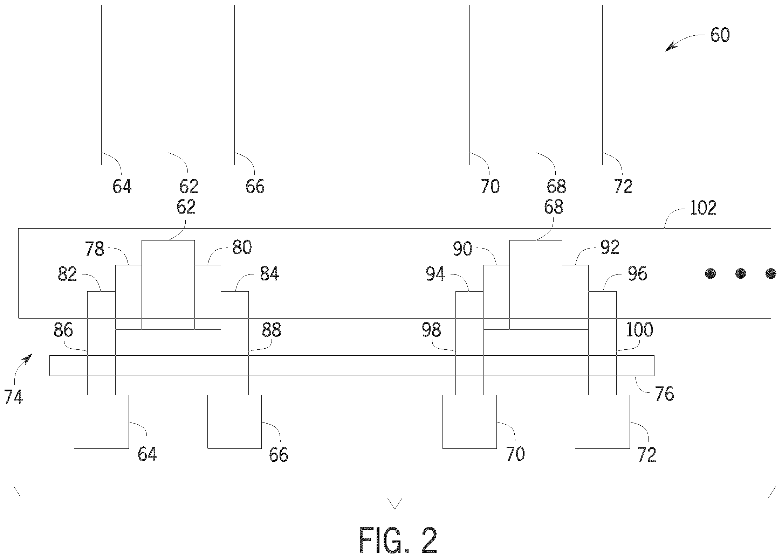

FIG. 2 is a top view 60 of lines of ferroelectric memory cells of FIG. 1 and a side view 74 of the lines in the memory cells of FIG. 1 with additional connections. As illustrated, a ferroelectric memory device (e.g., memory device 10) may utilize a plate line (PL) 62 that provides a plate voltage to multiple cells in a row/column. Each PL is flanked by two digit lines that are utilized for cells connected to the respective PL. For instance, the PL 62 is flanked by DL 64 and DLB 66 at each cell along the PL 62. For instance, PL 68 may be flanked by DL 70 and DLB 72. Other plate lines may be used for other cells in other rows/columns.

In the side view 74, the PLs 62 and 68 utilize a wordline (WL) 76 to control access to respective cells. As illustrated, the PL 62 is sandwiched between ferroelectric layers 78 and 80. The ferroelectric layers 78 and 80 are adjacent to opposite sides of the PL 62. For instance, the ferroelectric layers 78 and 80 may be formed from ferroelectric oxides, lead zirconium titanate, and/or other materials that have ferroelectric properties. Opposite the sides of the ferroelectric layers 78 and 80 coupled to and adjacent to the PL 62, the ferroelectric layers 78 and 80 are coupled to conductors 82 and 84 that may be extensions of source or drain terminals of respective selectors 86 and 88. The selectors 86 and 88 may be transistors. Instead, as discussed below, a write back circuit that works with higher voltages may be used to write back to the DL 64 and/or the DLB 66. The ferroelectric layer 78 connected to the PL 62 and the conductor 82 form a first cell while the ferroelectric layer 80 connected to the PL 62 and the conductor 84 form a second cell. The selectors 86 and 88 select the respective cells using the WL 76.

Similarly, the PL 68 is sandwiched between ferroelectric layers 90 and 92 with the ferroelectric layers 90 and 92 adjacent to opposite sides of the PL 68. Like the ferroelectric layers 78 and 80, the ferroelectric layers 90 and 92 may be formed from ferroelectric oxides, lead zirconium titanate, and/or other materials that have ferroelectric properties. Opposite the sides of the ferroelectric layers 90 and 92 coupled to and adjacent to the PL 68, the ferroelectric layers 90 and 92 are coupled to conductors 94 and 96 that may be extensions of source or drain terminals of respective selectors 98 and 100. The selectors 98 and 100 may be of the same type, materials, and/or characteristics as the selectors 86 and 88. The ferroelectric layer 90 connected to the PL 68 and the conductor 94 form a first cell while the ferroelectric layer 92 connected to the PL 68 and the conductor 96 form a second cell. The selectors 98 and 100 select the respective cells using the WL 76.

Although the foregoing discusses using a PL for the cells, in some embodiments, at least two of the PLs (e.g., PL 62 and 68) may be merged into a single plate 102 shared between at least 4 digit lines (e.g., DL 64, DLB 66, DL 70, and DLB 72).

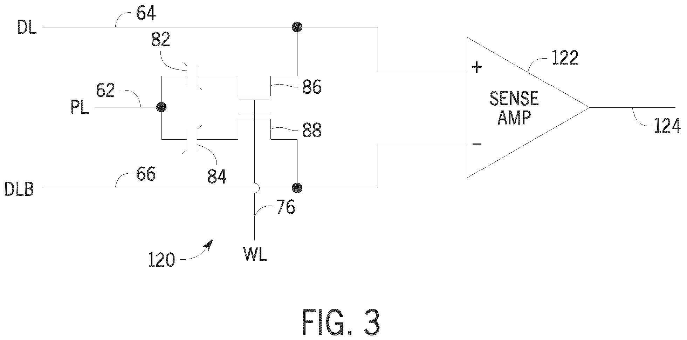

FIG. 3 is a circuit diagram of a connection 120 of the PL 62 through ferroelectric layers 78 and 80 via selectors 86 and 88 to the DL 64 and the DLB 66, respectively. The DL 64 and the DLB 66 are received at a sense amplifier 122 as a differential signal. The sense amplifier 122 may be one of the sense amplifiers 13 of FIG. 1. The sense amplifier 122 utilizes this differential signal to output a value 124. In some embodiments, the sense amplifier 122 may also send a complementary value along with the value 124.

Memory devices (e.g., FeRAM) may be implemented using 1T1C or 2T2C configurations. 2T2C implementations provide a higher probability of a correct interpretation and provides faster speeds. However, the 2T2C implementation consumes more resources regarding financial costs, power costs, and area costs. The decision to use 1T1C and 2T2C may vary based on particular use cases.

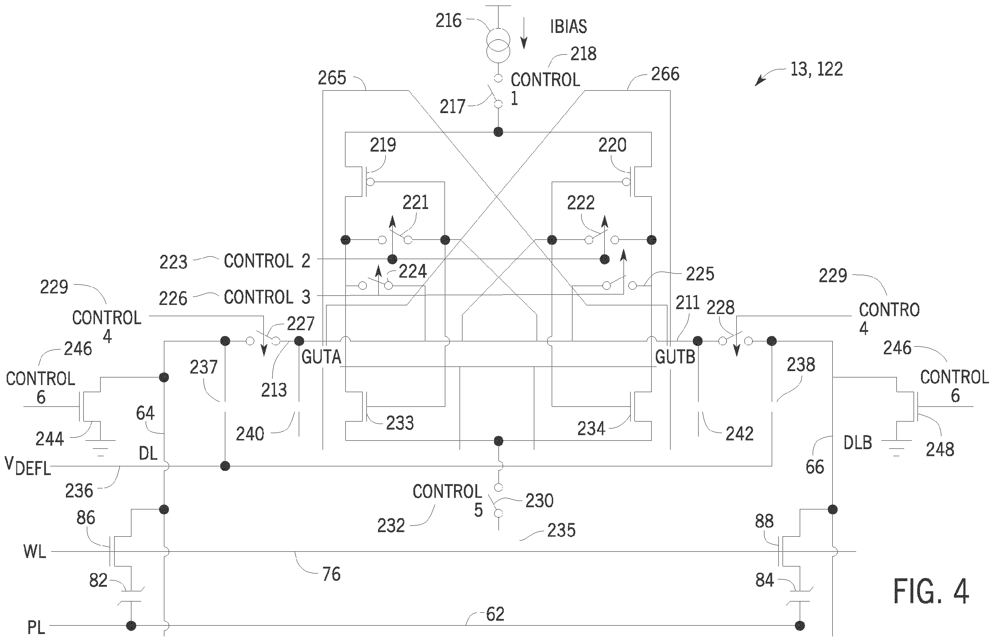

FIG. 4 is a block diagram of the sense amplifier 13 or 122. The sense amplifier 13 includes a current source 216 that provides a bias current and/or a bias voltage (e.g., up to 1.2V). The sense amplifier 13 also includes switch 217 that uses a control1 signal 218 to selectively couple the current source 216 to terminals (e.g., drain or source terminals) of PMOS transistors 219 and 220. In some embodiments, the terminals of the PMOS transistors 219 and 220 may be coupled to one or more current sources 216 using separate switches each controlled by the control1 signal 218.

The gate terminal of the PMOS transistor 219 is coupled to a gut node 211 of the sense amplifier 13, and the gate terminal of the PMOS transistor 220 is coupled to a gut node 213 of the sense amplifier 13. The other terminal (e.g., drain or source) of the PMOS transistor 219 is coupled to a switch 221 and a switch 224. The other terminal (e.g., drain or source) of the PMOS transistor 220 is coupled to a switch 222 and a switch 225. The switches 221 and 222 are controlled by a control2 signal 223 that selectively couples the respective other terminals of the PMOS transistors 219 and 220 to their respective gate terminals. As discussed below, this selectively coupling makes a negative feedback amplifier/inverting amplifier/inverter equivalent to a unit gain amplifier.

The switches 224 and 225 are controlled by a control3 signal 226. Based on the controls signal 226, the switch 224 selectively couples the other terminal of the PMOS transistor 219 to the gut node 213. Similarly, based on the controls signal 226, the switch 225 selectively couples the other terminal of the PMOS transistor 220 to the gut node 211.

The sense amplifier 13 also includes switches 227 and 228 that are controlled using a control4 signal 229. Based on the control4 signal 229, the switch 227 selectively couples the gut node 213 to the DL 64. Similarly, based on the control4 signal 229, the switch 228 selectively couples the gut node 211 to the DLB 66. In other words, the cotnrol4 signal 229 acts as an isolation signal that may be used to selectively decouple the sense amplifier 13 from the DL 64 and the DLB 66.

The sense amplifier 13 further includes a switch 230 that utilizes a control5 signal 232 to selectively couple and decouple a terminal (e.g., drain) of NMOS transistors 233 and 234 to V_{neg} 235. In FeRAM devices, the operating voltage cannot just be a middle point (e.g., 0.5V) between the upper and lower voltages (VCC (e.g., 1V) at the current source 216 and VSS (e.g., 0V)). This middle point strategy between two positive voltages is not readily available for FeRAM devices because the ferroelectric layers 90 and 92 must rest near 0V. Accordingly, Vneg 235 may be a voltage level below 0V or may be any voltage lower than a voltage between the switch 217 and the PMOS transistors 219 and/or 220. A terminal of the NMOS transistor 233 is coupled to the terminal of the PMOS transistor 219 and to the switches 221 and 224, and a terminal of the NMOS transistor 234 is coupled to a terminal of the PMOS transistor 220 and to switches 222 and 225. The gate of the NMOS transistor 233 is coupled to the gate of the PMOS transistor 219 and to the gut node 213, and the gate of the NMOS transistor 234 is coupled to the gate of the PMOS transistor 220 and to the gut node 211.

As discussed below, the sense amplifier 13 may apply a deflection voltage 236 that enables the sense amplifier 13 to help track the voltage difference in the memory cells by increasing the voltage difference between the DL 64 and the PL 62. The deflection voltage 236 may utilize a counter to inject current to shift the DL 64 and the DLB 66 lower to aid in extracting the voltage from the PL 62 to the DL 64. The deflection voltage 236 may be applied to the DL 64 and the DLB 66 via capacitors 237 and 238. The capacitors may be MOSFET devices that are configured as capacitors.

Additionally, the sense amplifier 13 may include some capacitance on the lines coupled to the gut nodes 213 and 211 that are illustrated as capacitors 240 and 242. Although these capacitors 240 and 242 are shown as distinct capacitive devices, the capacitance may be parasitic capacitance of the lines connecting various components of the sense amplifier 13.

Furthermore, the sense amplifier 13 includes a transistor 244 (e.g., an NMOS or PMOS transistor) that selectively couples the DL 64 to ground (e.g., VSS) based on a control6 signal 246 to drive (e.g., discharge charge from) the DL 64 toward the connected voltage via the transistor 244. In some embodiments, the voltage selectively coupled to the DL 64 via the transistor 244 may be different than VSS/ground and may be any voltage to which the DL 64 may be driven. Likewise, the sense amplifier 13 includes a transistor 248 (e.g., an NMOS or PMOS transistor) that selectively couples the DLB 66 to ground (e.g., VSS) based on the control6 signal 246 to drive (e.g., discharge charge from) the DLB 66 toward the connected voltage via the transistor 248. In some embodiments, the voltage selectively coupled to the DLB 66 via the transistor 248 may be different than VSS/ground and may be any voltage to which the DLB 66 may be driven. In some embodiments, the voltages selectively coupled to the DL 64 via the transistor 244 and to the DLB 66 via the transistor 248 may be the same as each other or may be different from each other.

As is discussed in more detail below, the PMOS transistor 219 and the NMOS transistor 233 are coupled together as an inverter 265 (e.g., complementary metal oxide semiconductor (CMOS) inverter) with the voltage of the gut node 211 as an input to the inverter 265 and with an output to the switch 224. Similarly, the PMOS transistor 220 and the NMOS transistor 234 are coupled together as an inverter 266 (e.g., CMOS inverter) with the voltage of the gut node 213 as an input to the inverter 266 and with an output to the switch 225.

Although the switches 217, 221, 222, 224, 225, 227, 228, and 230 are illustrated as generic switches, they may be implemented with any suitable switch embodiment. For instance, for the purposes of the following discussion, the switch 217 is implemented using a PMOS transistor while the switches 221, 222, 224, 225, 227, 228, and 230 are implemented using NMOS transistors. However, other implementations for these switches may be used in other embodiments with the respective control signals changed accordingly.

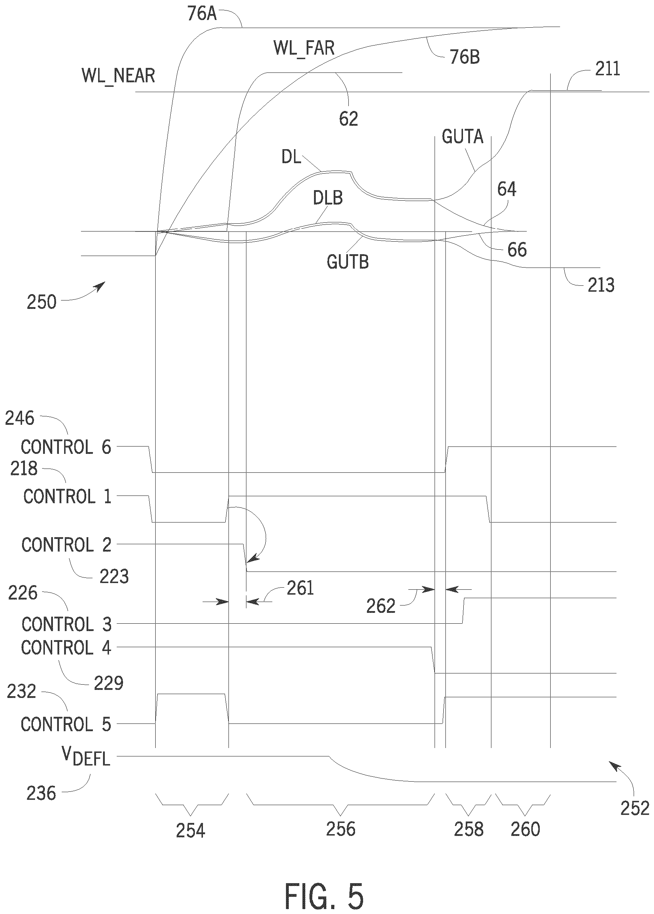

FIG. 5 shows a graph 250 and a timing diagram 252 for utilizing the sense amplifier 13 across phases 254, 256, 258, and 260. The phase 254 is a VTH compensation phase where the respective characteristics or "VTHs" of the inverters 265 and 266 are compensated for by putting sufficient charge on the DL 64 for the inverter 266 and on the DLB 66 for the inverter 265 to cause the inverters 265 and 266 to respond similarly by enhancing/optimizing the gains for the inverters 265 and 266 on their respective input-output curves. The phase 254 includes disconnecting the DL 64 and the DLB 66 from voltages (e.g., VSS) using the control6 signal 246 via the transistors 244 and 248 to enable charging of the DL 64 and the DLB 66 corresponding to the characteristics of the inverters 265 and 266. The phase 254 also includes turning on the switch 217 via the control1 signal 218 transitioning low to turn on the switch 217 (PMOS transistor). The control5 signal 232 is also asserted (high for NMOS transistor) so that, along with assertion of the control1 signal 218, the bias current is enabled to flow. The control2 signal 223 is also asserted (e.g., high) during the phase 254 causing switches 221 and 222 to activate. The activation of the switches 221 and 222 (NMOS transistors) causes the inputs and outputs of the inverters 265 and 266 to be tied together causing the inverters 265 and 266 to function as a unity gain amplifier that accelerates the settling of the voltages of the DL 64 and the DLB 66. The control3 signal 226 is low causing the switches 224 and 225 (NMOS transistors) to be off thereby decoupling the inverter 265 from the gut node 213 and decoupling the inverter 266 from the gut node 211. The control4 signal 229 is also high causing the switches 227 and 228 (NMOS transistors) to be on thereby respectively connecting the gut nodes 213 and 211 to the DL 64 and the DLB 66. This enables charges to be stored on the DL 64 corresponding to and proportional to the characteristics (or VTH) of the inverter 266 and on the DLB 66 corresponding to the characteristics (or VTH) of the inverter 265. The stored "VTH" may include the bias from the current source 216.

Further, during phase 254, the WL 76 turns on. The WL 76 is represented in the graph 250 as a WL_near 76A for WLs near the WL driver and as WL_far 76B for WLs far from the WL driver of the memory device 10. The WL 76 may be turned on during the phase 254 to improve tRCD (i.e., time to open a row and access a column of memory cells). This early turn on anticipates the RC delays to the voltage evolution of the WL_far 76B. The PL 62 also remains off. Additionally, during phase 254, the control5 signal 232 is high to turn off the switch 230.

After the phase 254 and at the beginning of the phase 256, the control1 signal 218 transitions high, and the control5 signal 232 transitions low. The control1 signal 218 and the control5 signal 232 transitioning causes the bias current to be cut off and the gut nodes 211 and 213 to be in a high impedance state.

After a delay 261 enabling the transition of the control1 signal 218 and the control5 signal 232 to complete, the control2 signal 223 is de-asserted (e.g., low for NMOS) causing the inverters 265 and 266 to no longer be configured to function as unity gain amplifiers. Also, during phase 256, the PL 62 transitions high, and the deflection voltage 236 is also issued to the sense amplifier 13 via the capacitors 237 and 238. In some embodiments, as illustrated, the sense amplifier 13 may apply the deflection voltage 236 during the phase 254 in addition or in alternative to applying the deflection voltage 236 during the phase 256.

During the phase 256, the connected memory cells are biased, and their charges are dumped on the DL 64 and the DLB 66 and a voltage is developed on the DL 64, the DLB 66, and the gut nodes 211 and 213, as shown in the graph 250.

Also, as illustrated in the timing diagram 252, the deflection voltage 236 is reduced during the phase 256 after time is given for the voltage difference between the gut nodes 211 and 213 to develop. This reduction of the deflection voltage 236 enables the overall voltage to be lowered for the gut nodes 211 and 213, the DL 64, and the DLB 66 without negatively impacting the voltage difference and fidelity of the output of the sense amplifier 13.

During the phase 258, the signal in the sense amplifier 13 is amplified by the NMOS transistors. Specifically, the control4 signal 229 is used to disconnect the DL 64 from the gut node 213 and to disconnect the DLB 66 from the gut node 211. After a delay 262 enabling the control4 signal 229 to isolate the gut nodes 211 and 213 from the DL 64 and DLB 66, the control6 signal 246 is used to set the DL 64 and the DLB 66 to some voltage (e.g., VSS) via transistors 244 and 248 without impacting the voltages of the gut nodes 211 and 213. Likewise, after the delay 262, the control5 signal 232 toggles the switch 230 to enable amplification on the gut node 211 and 213 using the NMOS devices.

At the beginning of phase 260, the control1 signal 218 is asserted to enable PMOS amplification while NMOS amplification continues from the phase 258 into the phase 260. In other words, the connection of the NMOS transistors 233 and 234 with the PMOS transistors 219 and 220 completes the latch connection. In such a configuration, the inverters 265 and 266 (with their respective PMOS transistors 219 and 220) amplify (e.g., negative amplification) the signal on the gut nodes 211 and 213 due to VTH compensation enhancing/optimizing the responses of the inverters 265 and 266 specific to their own characteristics. Due to this VTH compensation of the inverters 265 and 266, the difference in the values stored from the cells may be greatly increased. Furthermore, any error that may be introduced in sensing may be lower than the signals on the gut nodes 211 and 213 after amplification and/or than the voltage differences between the gut nodes 211 and 213 is increased.

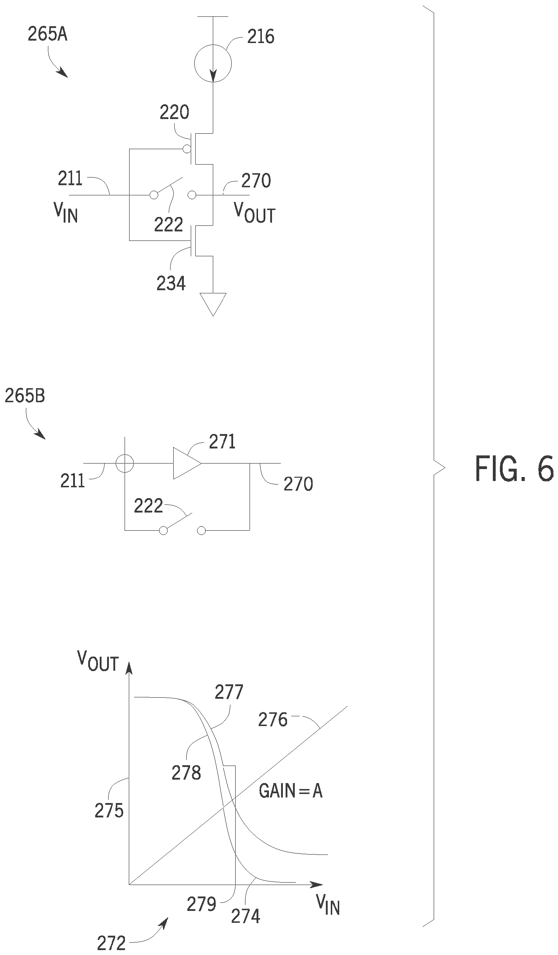

FIG. 6 is a simplified diagram of an inverter 265A that is a visualization of the inverter 265. The inverter 265 operates using the PMOS transistor 220 and the NMOS transistor 234 coupled as a CMOS inverter between the current source 216 for the bias current. The inverter 265 includes a switch 222 couples the input (e.g., gut node 211) of the inverter 265 with an output 270 of the inverter 265. The output 270 of the inverter 265 may be coupled to the switch 225 and/or the gut node 213 depending on whether the switch 225 is open or closed.

FIG. 6 also includes a simplified diagram of an inverter 265B that is another visualization of the inverter 265 during the VTC operation in the phase 254. The inverter 265B shows the inverter 265 as an inverter 271 (e.g., inverting amplifier) that has a feedback loop from the output 270 to the input (e.g., gut node 211) when the switch 222 is closed. FIG. 6 further depicts a graph 272 depicting a response curve plotting a voltage input 274 versus a voltage output 275. The graph 272 includes an input response curve 276 that plots the input voltages to the inverter 265B based on the input voltages along the x-axis of the graph and an output response curve for a unity gain amplifier. The graph 272 further includes an output response curve 277 that indicates a voltage of the output 270 based on the input voltages. This output response curve 277 may vary from one implementation of the inverter 265 to another embodiment of the inverter 265 due to specific characteristics while another implementation of the inverter 265 corresponding to output response curve 278 may have different characteristics even if the same design. For instance, the thickness of the transistors may vary even by a very small degree/percentage, the transistors of the different implementations may have aged differently, and/or any other properties between the characteristics may vary. The different output response curves 277 and 278 may have different responses at different voltages as the gain of the inverters 265B may be -A that is the slope or ratio of the change (e.g., negative) in output voltage divided by the change (e.g., positive) in input voltage. Due to these differences in slope at a specific input voltage (e.g., at line 279), the implementation corresponding to the output response curve 277 may have a greater negative gain than the output response curve 278 for the same input voltage.

One way to minimize these variances between different implementations of the inverters 265 or 266, the VTC compensation in the phase 254 may be used to place both inverters 265 and 266 at an improved or ideal location near the centers of the output response curves 277 and 278 to enhance or even optimize amplification. This may be done by shorting the inputs and outputs of the inverters 265 and 266 during the phase 254 by configuring the inverters 265 and 266 as unity gain amplifiers by switching switches 221 and 222. Once the feedback is removed by opening the switches 221 and 222, the voltage remains the same at the output at this point of equilibrium where the corresponding output response curve 277 or 278 matches the input response curve 276. Subsequently, when the input voltage changes in the subsequent phases 256-260, the corresponding output value moves more due to placing the output voltage at the intersection of the input response curve 276 and the corresponding output response curve 277 or 278. At this point, the gain is at or near (e.g., within 5%, 10%, 25% or another percentage of) the maximum amplification value. This greater amplification causes a greater difference between the differential signal from the memory cells before being dumped back on the DL 64 and the DLB 66. This greater difference causes the data stored in the memory cells to be properly sensed in the sense amplifier 13.

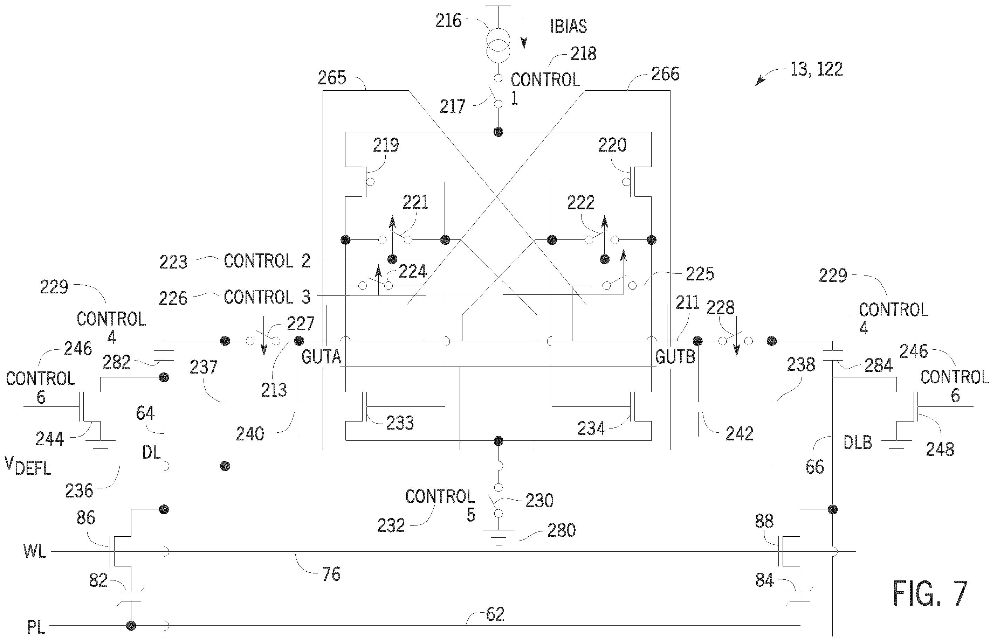

FIG. 7 is a schematic diagram of an embodiment of the sense amplifiers 13, 122. The embodiment in FIG. 7 is similar to the embodiment in FIG. 4 except that the embodiment of FIG. 7 uses a ground connection 280 instead of Vneg 235 at a negative voltage. However, to enable the required rest near 0V for FeRAM, the sense amplifier of FIG. 7 includes decoupling capacitors 282 and 284 that are used to bring the voltages of the DL 64 and the DLB 66 to at or around 0V. Thus, the voltage across the decoupling capacitors 282 and 284 is the difference between at or around 0V and an offset at the gut nodes 211 and 213 at least partially attributable to an offset from the current source 216.

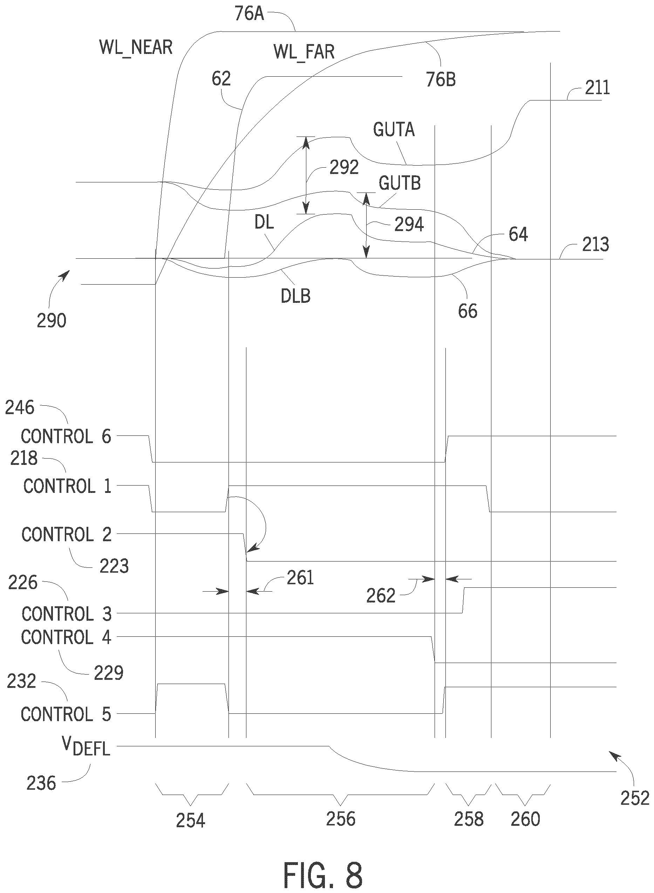

FIG. 8 shows a graph 290 and the timing diagram 252 for utilizing the sense amplifier 13 across phases 254, 256, 258, and 260. The graph 290 is similar to the graph 250 except that the voltages of the gut nodes 211 and 213 are offset from the voltages of the DL 64 and the DLB 66 by the decoupling capacitors 282 and 284. For instance, the voltage of the gut node 211 may be greater than the voltage of the DL 64 by an offset voltage 292 across the decoupling capacitor 282. Likewise, the voltage of the gut node 213 may be greater than the voltage of the DLB 66 by an offset voltage 294 across the decoupling capacitor 284. Thus, the gut voltages may operate at a mid-point voltage between an upper voltage and 0V while the voltage on the DL 64 and DLB 66 rests at or near 0V. For instance, before phase 254 and at the end and after the end of the phase 260, the DL 64 and the DLB 66 may be at or around 0V. The timing diagram 252 for FIGS. 5 and 8 are the same.

While the present disclosure may be susceptible to various modifications and alternative forms, specific embodiments have been shown by way of example in the drawings and have been described in detail herein. However, it should be understood that the present disclosure is not intended to be limited to the particular forms disclosed. Rather, the present disclosure is intended to cover all modifications, equivalents, and alternatives falling within the spirit and scope of the present disclosure as defined by the following appended claims.

## Claims

1. A memory device, comprising
a plurality of ferroelectric layer-based memory cells to store data;
a plurality of first digit lines (64) each coupled to a respective ferroelectric layer-based memory cell of a first set of the plurality of ferroelectric layer-based memory cells;
a plurality of second digit lines (66) each coupled to a respective ferroelectric layer-based memory cell of a second set of the plurality of ferroelectric layer-based memory cells; and
a plurality of sense amplifiers (122) each respectively coupled to a first digit line (64) from the plurality of first digit lines (64) and to a second digit line (66) from the plurality of second digit lines (66), wherein each of the plurality of sense amplifiers (122) comprises a pair of inverters (265, 266) configured to selectively couple to the first and second digit lines (64, 66), and each inverter (265, 266) of the pair of inverters (265, 266) comprises a switch (221, 222) configured to cause the respective inverter (265, 266) to function as a unity gain amplifier during a compensation phase of the memory device.

2. The memory device of claim 1, wherein each of the sense amplifiers (122) of the plurality of sense amplifiers (122) is configured to sense and amplify a voltage difference between voltages on the respective first and second digit lines (64, 66).

3. The memory device of claim 1, wherein each of the first set of the plurality of ferroelectric layer-based memory cells is configured to store data, and each of the second set of the plurality of ferroelectric layer-based memory cells is configured to store complementary data.

4. The memory device of claim 3, wherein the first digit lines (64) are configured to carry the data.

5. The memory device of claim 4, wherein the second digit lines (66) are configured to carry a complement of the data.

6. The memory device of claim 1, comprising a current source (216) that selectively supplies a current to the pair of inverters (265, 266).

7. The memory device of claim 1, wherein each of the switches (221, 222) is configured to couple together an input and an output of the respective inverter (265, 266) during the compensation phase before one or more amplification phases of the respective sense amplifier (122).

8. The memory device of claim 1, wherein the pair of inverters (265, 266) comprises:
a first complementary metal-oxide semiconductor inverter (265); and
a second complimentary metal-oxide semiconductor inverter (266).

9. The memory device of claim 1, wherein the compensation phase is configured to cause the pair of inverters (265, 266) to amplify input values similarly during one or more amplification phases.

10. The memory device of claim 1, wherein the compensation phase is configured to settle input and output voltages of the pair of inverters (265, 266) to enhance gains of the pair of inverters (265, 266).

11. The memory device of claim 10, wherein the gains are negative gains.

12. The memory device of claim 10, wherein the gains of the pair of the inverters (265, 266) are optimized at respective locations on respective characteristic-dependent output response curves corresponding to a greatest gain of the respective characteristic-dependent output response curves.

13. A method, comprising:
Toggling a first switch (221) in a sense amplifier (122) during a compensation phase to couple a first input of a first inverter (265) to a first output of the first inverter (265) to cause the first inverter (265) of the sense amplifier (122) to be configured as a unity gain amplifier during the compensation phase of the sense amplifier (122) to cause amplification in the first inverter (265) to be enhanced in subsequent amplification phases of the sense amplifier (122) by storing a first charge on a first digit line (64) of the sense amplifier (122);
toggling a second switch (222) in the sense amplifier (122) during the compensation phase to couple a second input of a second inverter (266) to a second output of the second inverter (266) to cause the second inverter (266) of the sense amplifier (122) to be configured as a unity gain amplifier during the compensation phase of the sense amplifier (122) to cause amplification in the second inverter (266) to be enhanced in the subsequent amplification phases of the sense amplifier (122) by storing a second charge on a second digit line (66) of the sense amplifier (122);
in an amplification phase, disconnecting the first input from the first output;
in the amplification phase, disconnecting the second input from the second output; and
amplifying a signal difference from memory cells corresponding to the sense amplifier (122) by using the enhanced amplification in the first and second inverters (265, 266).

14. The method of claim 13, comprising applying a deflection voltage to reduce voltages in the first and second digit lines (64, 66) during a voltage level development between the compensation phase and the subsequent amplification phases.

15. The method of claim 14, comprising applying the deflection voltage via capacitors coupled to the first and second digit lines (64, 66).
